# EUROPEAN PATENT APPLICATION

(11) **EP 2 377 809 A1**
(43) Date of publication of application: **19.10.2011**
(21) Application number: 10160200.1
(22) Date of filing: 16.04.2010
(51) Int. Cl.: B81C 1/00

(54) **Method for Manufacturing a Hermetically Sealed Structure**

(71) Applicant: SensoNor Technologies AS, 3192 Horten (NO)
(72) Inventor: Kittisland, Gjermund, N-3192, Horten (NO); Lapadatu, Daniel, N-3192, Horten (NO); Jacobsen, Sissel, N-3192, Horten (NO); Westgaard, Trond, 1358, Jar (NO)
(74) Representative: Haley, Stephen

(57) **Abstract**

A method for providing hermetic sealing within a silicon-dielectric composite wafer for manufacturing a hermetically sealed structure, comprising the steps of: patterning a first silicon wafer to have one or more recesses and filling said recesses with a dielectric material to form a first composite wafer having a plurality of silicon-dielectric interfaces, said first composite wafer having one or more bonding surfaces, and a further outer surface comprising a layer of dielectric material only; and using an anodic bonding technique to create hermetic sealing between silicon-dielectric interfaces within the first composite wafer.

## Description

The invention relates to a method for manufacturing a micro-electromechanical system (MEMS) structure for a high-precision, high-stability MEMS device and, in particular, a method for providing hermetic sealing within a silicon-dielectric composite wafer for manufacturing a hermitically sealed structure.

There is a considerable need for high-precision and high-stability MEMS devices, such as angular rate sensors, accelerometers and the like, which are used for a variety of electronic measuring systems. These devices typically contain moving or vibrating components and are generally constructed in metal, quartz or silicon. Silicon based MEMS devices are preferred because they can be miniaturised and manufactured relatively cheaply in large production runs by batch manufacture.

Composite silicon-dielectric wafers, such as the silicon-glass composite wafer described in US 2004/0180517, are suitable for the manufacture of MEMS structures because they provide vertical electrical conductors through the wafer. Furthermore, the dielectric areas of the composite wafer are, in principle, excellent for anodic bonding to silicon wafers to create a hermetic seal.

Creating a composite wafer generally involves a "melt and mould" shaping technique, whereby recesses are etched into a silicon wafer to form a "mould" and a dielectric material, such as glass, is then melted to fill the recesses. Once solidified, the dielectric provides a seal along the silicon-dielectric interface in the composite wafer. EP-A-1436582 discloses a fabrication method for silicon-silicon oxide composite wafers and US 2004/180517 discloses a fabrication method for silicon-dielectric composite wafers.

The quality of the seal created between the silicon-dielectric interface in the composite wafer in these methods is, however, dependent on the "mechanical fit" of the dielectric against the interface at the silicon recess wall, which does not necessarily provide a hermetic seal. This can pose a risk for gas leaks along the silicon-dielectric interface.

Furthermore, when using an anodic bonding process to join the composite wafer to a silicon wafer, it is essential that any contact electrode being attached to the composite wafer only contacts the dielectric parts of the composite wafer. Otherwise, if the silicon in the composite wafer comes into simultaneous contact with the electrode and the silicon wafer having a further contact electrode attached, a short circuit will occur. This situation is not uncommon because one of the main reasons for using a composite wafer is to provide electrical connections through a wafer and thus prevents the use of standard commercial anodic bonding equipment to perform the bonding process because with standard anodic bonding equipment there is no way of aligning the contact points of the electrode systems according to the wafer pattern.

The present invention provides a solution to these problems and provides a method for manufacturing a hermetically sealed MEMS structure which allows standard tooling to be used and, furthermore, provides hermetic sealing within the composite structure.

According to the present invention there is provided a method for providing hermetic sealing within a silicon-dielectric composite wafer for manufacturing a hermetically sealed structure, comprising the steps of: patterning a first silicon wafer to have one or more recesses and filling said recesses with a dielectric material to form a first composite wafer having a plurality of silicon-dielectric interfaces, said first composite wafer having one or more bonding surfaces, and a further outer surface comprising a layer of dielectric material only; and using an anodic bonding technique to create hermetic sealing between silicon-dielectric interfaces within the first composite wafer

With the method of the present invention, the anodic bonding step is performed as an intermediate step during the process of manufacturing the composite wafer. The anodic bonding takes place after thinning and polishing of the silicon side of the composite wafer, but before thinning of the dielectric side. This ensures that a dielectric only surface will be provided for a contact electrode during the anodic bonding process, which allows any standard bonding tool with non-aligned contact positioning to be used. After bonding, the thinning and polishing of the dielectric side of the composite wafer may be completed.

Advantageously, when anodic bonding, an electrostatic field is applied across the silicon-dielectric interface within the composite wafer, which ensures an atomic level hermetically sealed join along the silicon-dielectric interface to the same level as for the industrially well established wafer level anodic bonding used by the MEMS industry.

The anodic bonding is preferably performed during wafer bonding of the composite wafer to the structured silicon substrate to create a hermetically sealed join between the composite wafer and the structured silicon substrate at the same time as the hermetic seal is created between the silicon-dielectric interface within the composite wafer. However, this depends on proper design and layout of the composite wafer in relation to the silicon substrate in order to ensure correct electrical connections and polarities to each part of the composite wafer and the structured silicon substrate.

Of course, anodic bonding could alternatively be applied to a composite wafer by itself as an additional step after the "melt and mould" step of the composite wafer manufacturing process, but prior to the final thinning of either the silicon or dielectric sides of the composite wafer to produce a finished composite wafer having a hermetically sealed silicon-dielectric interface.

The silicon parts of the composite wafer preferably form vertical through-conductors, fixed electrodes for capacitors and the dielectric-filled recesses form dielectric inserts arranged between the electrodes to provide them with electrical isolation.

Preferably, the planar silicon substrate is structured within the device layer of an SOI wafer, which ensures that the structured silicon substrate can have very accurate dimensions. Alternatively, the planar silicon substrate is structured within a silicon wafer. Advantageously, with the method of the present invention, the planar silicon substrate can be structured to define a plurality of components arranged to move in a MEMS device, including seismic masses, driving beams, bending spring, pedestals, contact and capacitor recesses.

The present invention improves on existing methods of manufacturing MEMS devices by providing a method for manufacturing a MEMS structure which can use double-sided excitation and detection to provide a device that can achieve considerably better accuracy and stability compared to existing arrangements.

Advantageously, the method of the present invention can provide a MEMS structure in which a structured silicon substrate is hermetically sealed between two capping silicon-dielectric composite wafers in vacuum or controlled gas atmosphere.

An example of the present invention will now be provided, with reference to the attached figures, in which:
Figure 1 shows a fabrication sequence for forming a first composite wafer of a sensor structure;
Figure 2 shows a fabrication sequence for forming a second composite wafer of the sensor structure;
Figure 3 shows a fabrication sequence to structure the front surface of a SOI wafer;
Figure 4 shows the machined SOI wafer and the first composite wafer sealed by means of anodic bonding to form a double stack wafer;
Figure 5 shows an enlarged partial view of the double-stack wafer of Figure 4, illustrating an example of a top side capacitor, a top side (internal) electrical contact and a top side stopper;
Figure 6 shows a fabrication sequence that removes excess materials from the double-stack wafer;
Figure 7 shows a fabrication sequence to structure the back surface of the double-stack wafer;
Figure 8 shows the machined double-stack wafer and second composite wafer sealed by means of anodic bonding to form a triple stack wafer;
Figure 9 shows an enlarged partial view of the triple-stack wafer of Figure 8, illustrating an example of a bottom side capacitor, a bottom side (internal) electrical contact and a bottom side stopper;
Figure 10 shows a fabrication sequence that removes excess materials from the triple-stack wafer; and
Figure 11 shows a fabrication sequence that creates external metallisation on the triple-stack wafer.

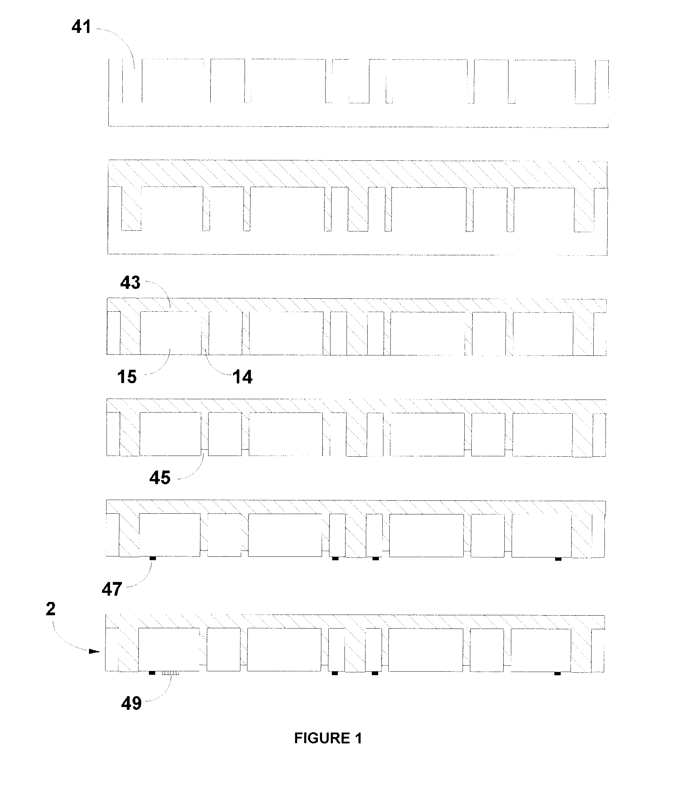

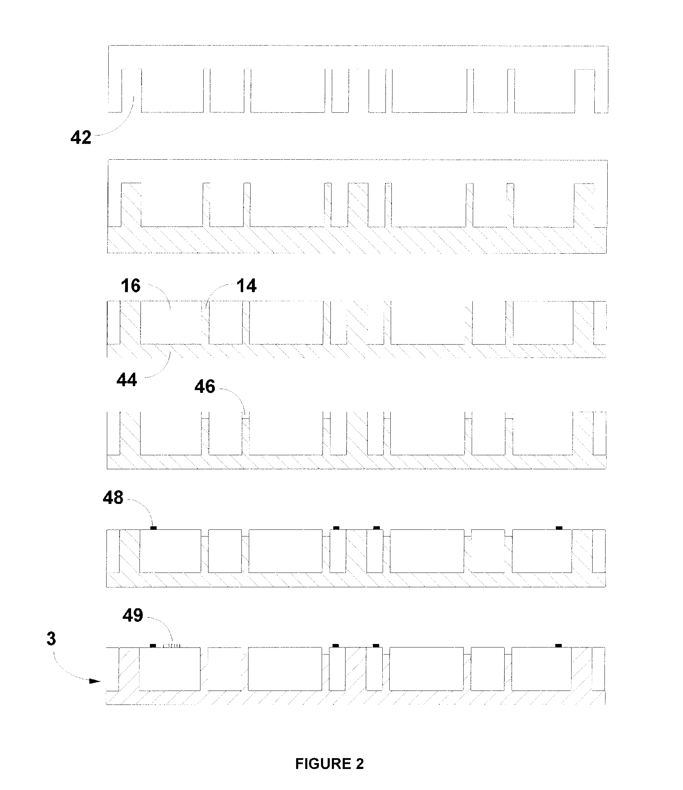

Figures 1 and 2 illustrate the fabrication sequence for structuring the top composite wafer 2 and bottom composite wafer 3, respectively. The first processing step consists in defining a pattern of recesses 41, 42 in a silicon wafer, preferably by deep reactive ion etching (DRIE).

The second processing step consists of providing dielectric material in the recesses 41, 42, preferably by reflowing borosilicate glass, to form dielectric inserts 14 that isolate portions of the silicon to form electrodes 15, 16. It will, of course, be recognised that any suitable dielectric material may be used to fill the recesses 41, 42 using any suitable method. Sufficient dielectric material is provided to completely cover the surface of the silicon wafer that the recesses 41, 42 were etched into.

The third processing step consists of removal of all excess silicon, for instance by mechanical grinding and chemical-mechanical polishing (CMP) of the silicon surface of the now composite wafer 2, 3. The surface completely covered with a layer of dielectric material can also be thinned and polished if necessary, although a contiguous layer of dielectric 43, 44 must be left on this surface.

To prevent the possibility of subsequent stiction between the moveable parts of the final device, the fourth processing step consists in locally etching the dielectric inserts 14 on a surface that is to be bonded in any particular areas that are not to be bonded, to form shallow recesses 45, 46.

The fifth processing step consists in depositing and patterning portions of a thin metal layer 47, 48, such as titanium or aluminium, on the upper or lower surface of the composite wafer 2, 3 the surface being that which is to be subsequently bonded. These thin metal layers 47, 48 will eventually form parts of internal electrical contacts, which will be described further on. Depending on the chosen sealing technique, additional thin metal layers may be deposited and patterned to serve as parts of the top side sealing elements.

Ideally, the thin metal layers 47, 48 should also serve as getter for the various gases that may affect in long term the damping of the various motions. Alternatively, a distinct, patterned getter material 49 can be applied to the surface of either or both top and bottom composite wafers 2, 3 in addition to the metal layers 47, 48.

It can be seen from the figures that, in this example of the present invention, the corresponding elements of the top and bottom composite wafers 2, 3 have identical pattern and thickness, thus conferring full symmetry to the final structure.

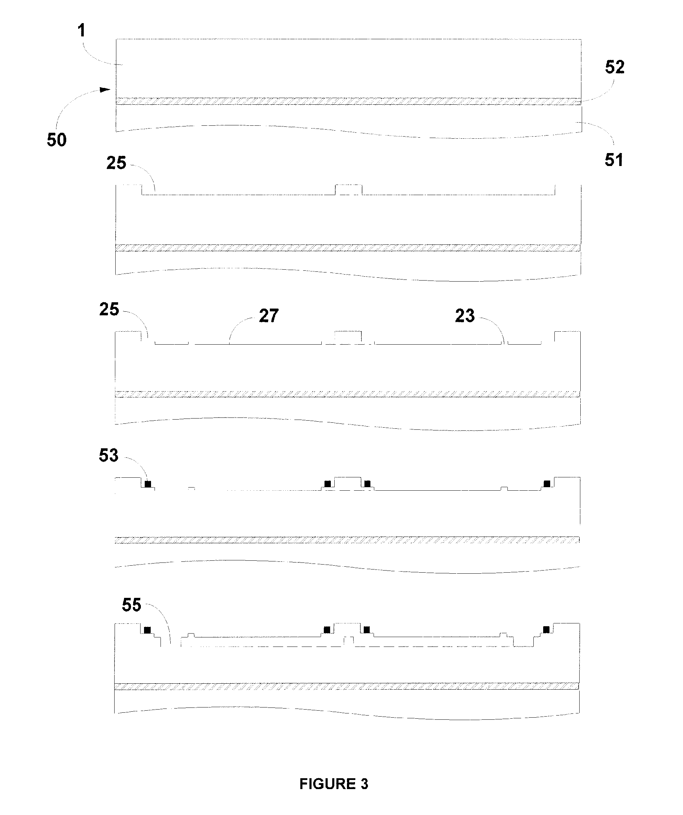

Figure 3 shows a silicon-on-insulator (SOI) wafer 50, consisting of a silicon device layer 1, in which moveable parts of, for example, an angular rate sensor are to be structured, and a handle wafer 51, separated by a buried oxide layer 52, which serves as an etch stop layer for a subsequent dry etching step. The fabrication sequence that structures the front surface of the SOI wafer 50 is as follows.

The first processing step of the SOI wafer 50 consists in defining a first, shallow, recess 25 within the silicon device layer 1 of the SOI wafer 50, to serve as requisite spacing for top side internal electrical contacts. The second processing step consists in defining a second, deeper, recess 27 within the silicon device layer 1 of the SOI wafer 50, serving as gap for a number of subsequent top side capacitors. The combination of the first recess 25 and second recess 27 enables the creation of silicon stoppers 23, at dedicated locations within the second recess 27, the stoppers 23 being employed to prevent stiction and accidental electrical short-circuiting.

The third processing step consists in depositing and patterning a thin metal layer 53, such as titanium or aluminium, to form a part of the top side internal electrical contacts.

The fourth processing step consists in defining the upper-half profile of the beams by dry etching a third, deeper, recess 55 within the silicon device layer 1 of the SOI wafer 50.

Although in this example of the present invention, the device layer of a SOI wafer is structured to form the moving parts of the exemplary device, these could alternatively be structured within a mono-crystalline silicon wafer. However, although using a SOI wafer can be slightly more complex, it is preferred over a mono-crystalline silicon wafer because it allows for better thickness control.

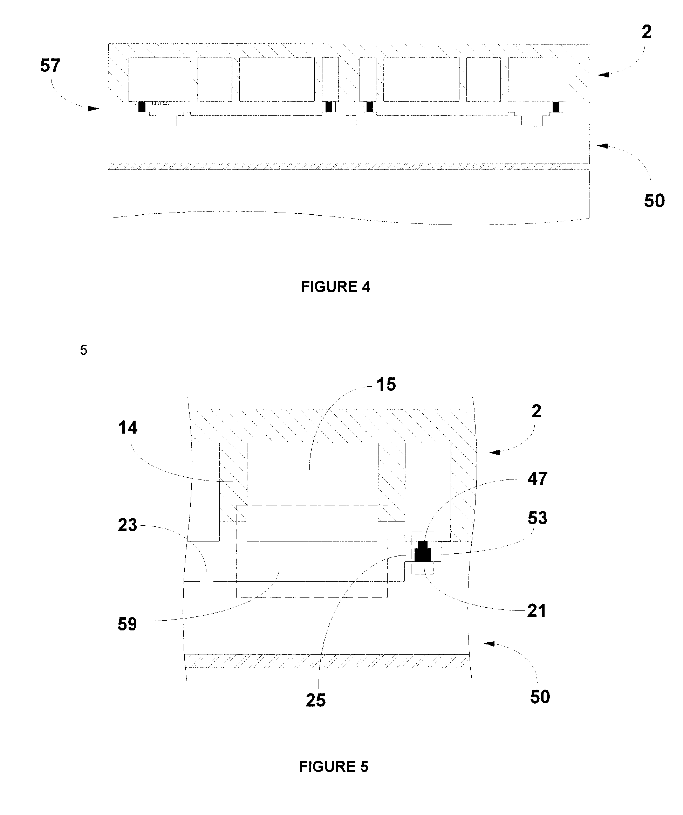

Figure 4 illustrates the machined SOI wafer 50 and the top composite wafer 2 sealed together to form a double-stack wafer 57 by means of anodic bonding.

Figure 5 shows a detailed view of the double-stack bonded wafer 57 after the top composite wafer 2 and structured SOI wafer 50 have been joined, illustrating an example of a top side capacitor 59, a top side internal electrical contact 21 and a top side stopper 23. The internal electrical contact 21 is formed by the thin metal layer 47 provided on the top composite wafer 2 and the thin metal layer 53 provided on the structured SOI wafer 50 being squeezed together during the joining process. To achieve a reliable internal electrical contact, the depth of the first recess 25 and the thickness of the metal layers 47 and 53 must be chosen with care and optimised to take into account the effect of the processing tolerances.

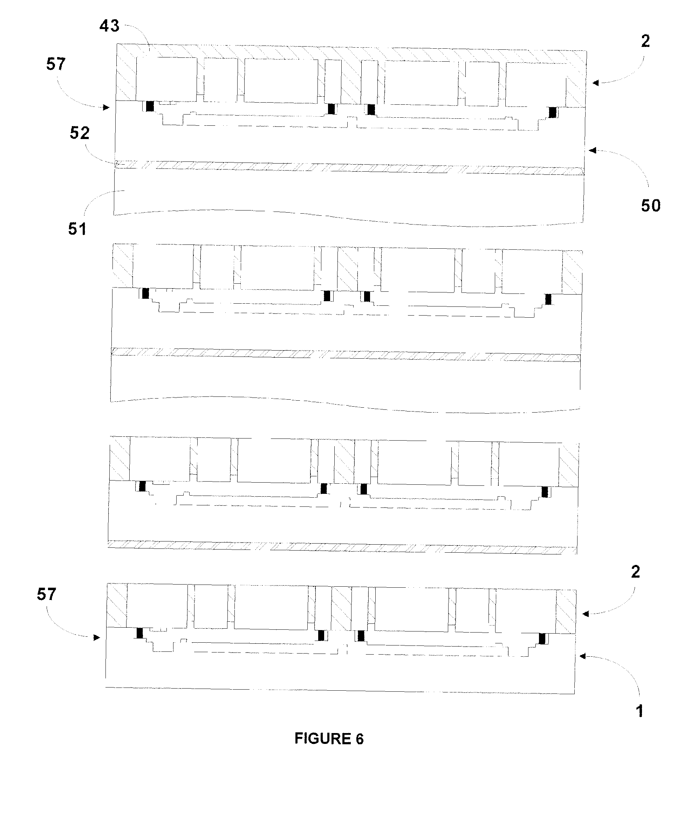

Figure 6 illustrates the next step of the fabrication sequence that removes the excess materials from the double-stack bonded wafer 57 once bonding has taken place. For instance, grinding, followed by CMP, can be used to remove the contiguous layer of dielectric 43, which was required in combination with the previous anodic bonding sealing technique, thus exposing the silicon pattern of the composite wafer 2. The handle layer 51 can then be removed by, for example, grinding, followed by reactive ion etching with etch stop on the buried oxide layer 52, with etching being used to remove the buried oxide 52 to expose the back surface of the released silicon device layer 1. An alternative option, but which is more expensive and time consuming, would be to remove the handle wafer 51 by etching only, with etch stop on the buried oxide layer 52.

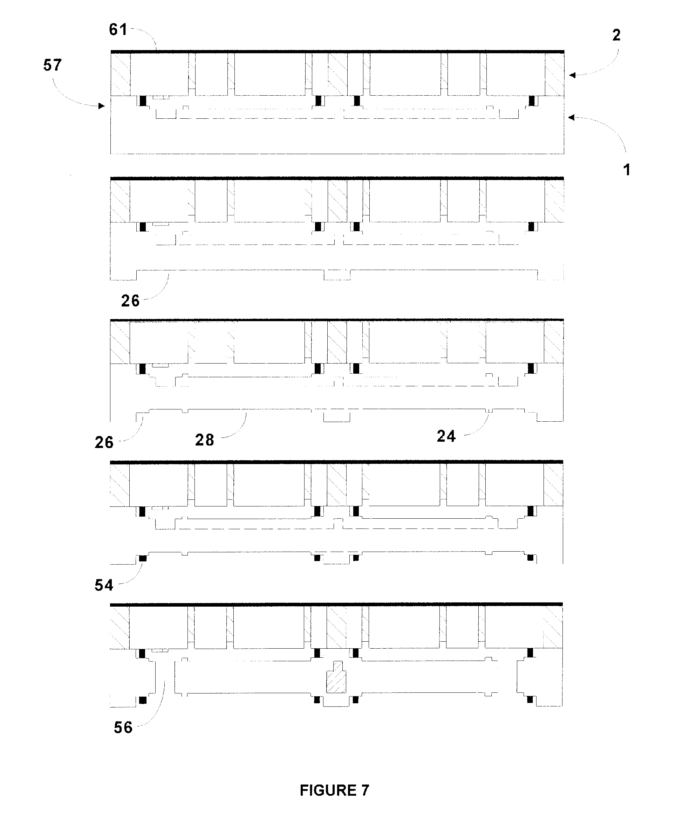

Figure 7 illustrates the fabrication sequence that structures the back surface of the silicon device layer 1. In this example, a thick, protective metal layer 61, such as aluminium, is shown deposited on the upper surface of the double-stack wafer 57 before the first processing step. This protective layer is, however, optional and is sometimes used to enhance the gripping force holding the wafer to electrostatic chucks during subsequent processing, as well as securing proper electrode contact during subsequent anodic bonding.

The first processing step of the double-stack bonded wafer 57 consists in defining a first, shallow recess 26 serving as requisite spacing for bottom side internal electrical contacts, explained further on..

The second processing step consists in defining a second, deeper recess 28 to serve as a capacitance gap for a number of subsequent bottom side capacitors.

In this example of the present invention, the first and second recesses 26, 28 provided on the back surface of the silicon device layer 1 have the same pattern and depth as the first and second recesses 25, 27 formed previously on the front surface of the silicon device layer 1

The combination of first, shallow recess 26 and second, deeper recess 28 enables the creation of bottom side silicon stoppers 24, at dedicated locations within the second recess 28, the stoppers 23 being employed to prevent stiction and accidental electrical short-circuiting.

The third processing step consists in depositing and patterning a thin metal layer 54, such as titanium or aluminium, to form a part of bottom side internal electrical contacts. The metal layer 54 on the back surface of the silicon device layer 1 preferably has the same composition, pattern and thickness as the metal layer 53 on the front surface of the silicon device layer 1.

The fourth processing step consists in releasing a portion of the silicon device layer forming the masses and beams by deep reactive ion etching 56.

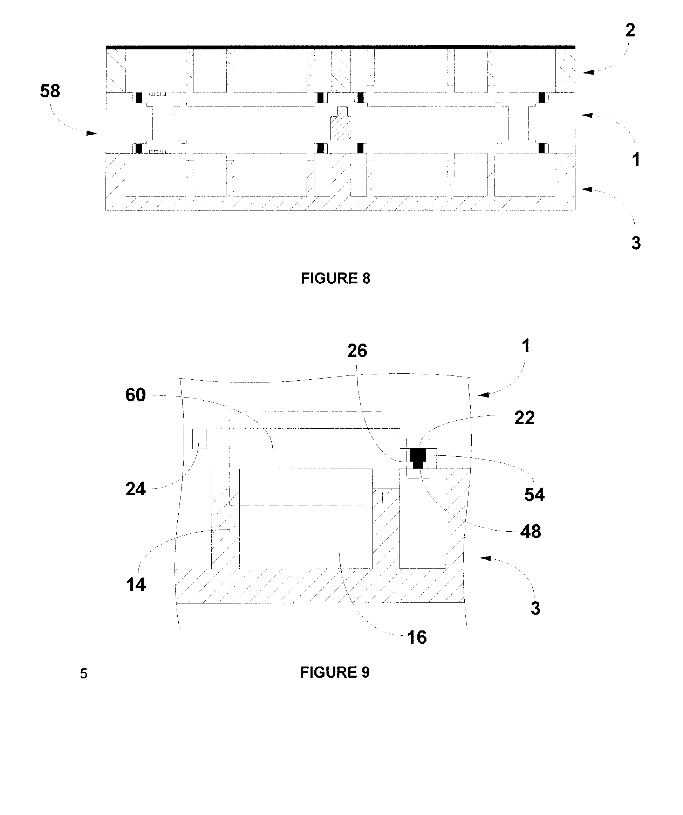

Figure 8 shows the double-stack bonded wafer 57 and the bottom composite wafer 3 sealed together to form a triple-stack bonded wafer 58 by means of anodic bonding.

Figure 9 shows a detailed view of the triple-stack bonded wafer 58 after the double-stack bonded wafer 57 and bottom composite wafer 3 have been joined together, illustrating an example of a bottom side capacitor 60, a bottom side internal electrical contact 22 and a bottom side stopper 24. As with the top side electrical contact 21, the bottom side internal electrical contact 22 is formed by the thin metal layer 48 provided on the bottom composite wafer 3 and the thin metal layer 54 provided on the silicon device layer 1 being squeezed together during the joining process. To achieve a reliable internal electrical contact, the depth of the back side shallow recess 26 and the thickness of the metal layers 48 and 54 must be chosen with care and optimised to take into account the effect of the processing tolerances.

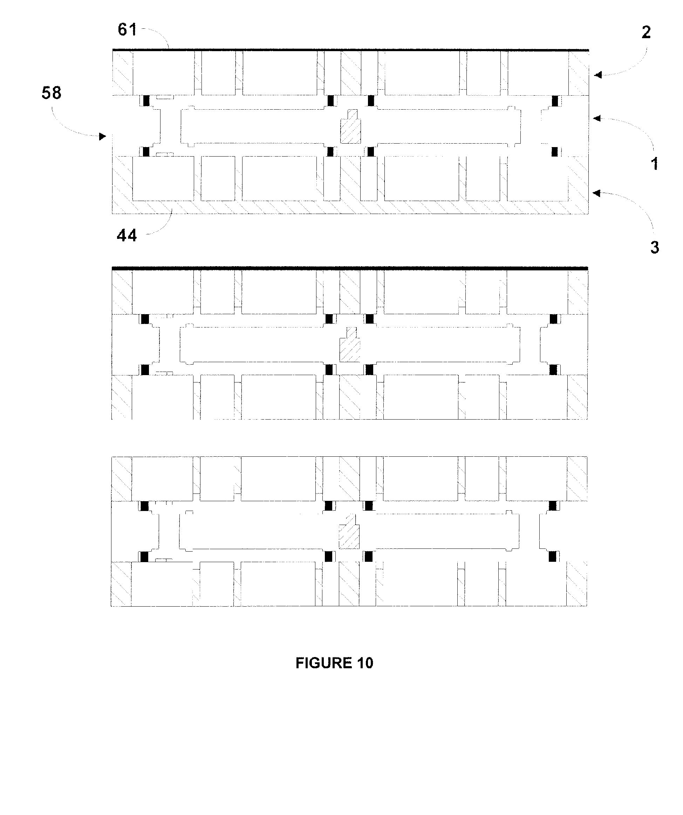

Figure 10 illustrates the next step of the fabrication sequence that removes the excess materials from the triple-stack bonded wafer 58. For instance, grinding, followed by CMP, can be used to remove the contiguous layer of dielectric 44, which was required in combination with the previous anodic bonding sealing technique, thus exposing the silicon pattern of the composite wafer 3. Wet etching is used to remove the front side protective metal layer 61, if present.

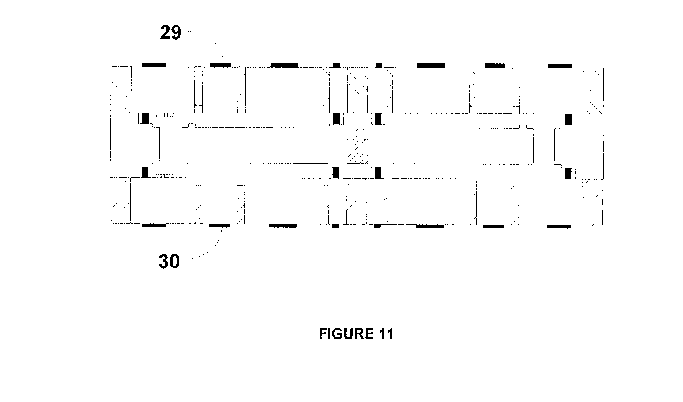

Figure 11 illustrates the fabrication sequence that creates the external metallisation on the triple-stack bonded wafer 58. Metal layers, suitable for forming an electrical contact, are deposited and subsequently patterned on the front and back surfaces of the triple-stack bonded wafer 58, to form the top side pads 29 and bottom side pads 30. Patterns in the same metal layers allow direct electrical connection between the pads and the corresponding silicon parts of the composite wafers 15, 16. A suitable singulation method can then be used to separate the individual chips.

Although other suitable bonding processes, such as, for example, direct bonding, eutectic bonding, plasma activated and thermo-compression bonding may be used to join the composite wafer to the structured silicon substrate, only anodic bonding creates a hermetic seal at the silicon-dielectric interface in the composite wafer. With other bonding methods, the hermeticity inherent between the silicon-dielectric interfaces in the composite wafer will depend solely on the "mechanical fit" provided by the "melt and mould" procedure.

In the above-described example of the present invention, the MEMS structure comprises both a first composite wafer 2 and a second composite wafer 3. A skilled person will, of course, recognise that a MEMS structure having any number of composite wafers may be produced using the method of the present invention. For example, if only a single composite wafer is used then the back surface of the silicon wafer 1 may not need to be processed as described in this example.

## Claims

1. A method for providing hermetic sealing within a silicon-dielectric composite wafer for manufacturing a hermetically sealed structure, comprising the steps of:
patterning a first silicon wafer to have one or more recesses and filling said recesses with a dielectric material to form a first composite wafer having a plurality of silicon-dielectric interfaces, said first composite wafer having one or more bonding surfaces, and a further outer surface comprising a layer of dielectric material only; and
using an anodic bonding technique to create hermetic sealing between silicon-dielectric interfaces within the first composite wafer.

2. The method of claim 1, further comprising the steps of:
providing a second silicon wafer having one or more topside bonding surfaces; and
joining the bonding surfaces of the first composite wafer to the topside bonding surfaces of the second silicon wafer.

3. The method of claim 2, wherein the step of joining the bonding surfaces is performed by aligning the bonding surfaces together before using the anodic bonding technique such that the anodic bonding technique creates a hermetic seal between silicon-dielectric interfaces within the first composite wafer and also at an interface between the bonding surfaces of the first composite wafer and the topside bonding surfaces of the second silicon wafer.

4. The method of any preceding claim, wherein the step of using an anodic bonding technique is performed before the layer of dielectric material is removed from the outer surface of the composite wafer.

5. The method according to any preceding claim, further comprising the step of patterning the topside bonding surface on the second silicon wafer before bonding.

6. The method of claim 5, further comprising the steps of:
patterning a backside surface of the second silicon wafer, thereby forming backside bonding surfaces; and
etching completely through the second silicon wafer to define a structured silicon substrate that is released from an outer portion of the second silicon wafer that is bonded to the first composite wafer.

7. The method of claim 6, further comprising the steps of:
preparing a second composite wafer in a similar manner to the first composite wafer; and
joining the bonding surfaces of the second composite wafer with the backside bonding surfaces of the second silicon wafer.

8. The method of any preceding claim, further comprising the step of providing, before joining the or each composite wafer(s) to the second silicon wafer, corresponding portions of metal layer on the one or more bonding surfaces of the or each composite wafer for providing internal electrical contacts.

9. The method of claim 8, wherein the portion of metal layers are also arranged to serve as a getter.

10. The method of claim 8, further comprising the step of providing a getter material to the bonding surface of either or both composite wafers.

11. The method of any preceding claim, further comprising the step of providing portions of metal layers on the outer surfaces of the or each composite wafer to form connecting pads, the portions of metal layers being arranged to allow direct electrical connection through the silicon parts of the composite wafers, which are isolated by the dielectric filled recesses to thereby form electrodes, and the internal electrical contacts.

12. The method of any preceding claim, wherein the second silicon wafer is a silicon-on-insulator wafer (SOI) or its device layer.

13. The method of any preceding claim, wherein the dielectric material is glass or silicon-dioxide.

14. A device manufactured using the method according to any preceding claim.

15. A plurality of devices according to claim 14, wherein a plurality of structures are patterned on each wafer and then bonded, before being singulated to form individual components.
